(19) Europäisches Patentamt
European Patent Office
Office européen des brevets

(11) EP 2 259 343 A1

(12) EUROPEAN PATENT APPLICATION
published in accordance with Art. 153(4) EPC

(43) Date of publication:
08.12.2010 Bulletin 2010/49

(51) Int Cl.:
H01L 33/00 (2010.01)    H01L 21/28 (2006.01)

(21) Application number: 09723712.7

(22) Date of filing: 13.03.2009

(86) International application number:
PCT/JP2009/054849

(87) International publication number:
WO 2009/119341 (01.10.2009 Gazette 2009/40)

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(30) Priority: 24.03.2008 JP 2008074875

(71) Applicant: Sony Corporation
Tokyo 108-0075 (JP)

(72) Inventors:
• HITSUDA, Yukihisa
Tokyo 108-0075 (JP)
• OHASHI, Tatsuo
Tokyo 108-0075 (JP)

(74) Representative: Müller - Hoffmann & Partner
Patentanwälte
Innere Wiener Strasse 17
81667 München (DE)

(54) SEMICONDUCTOR LIGHT EMITTING ELEMENT AND METHOD FOR MANUFACTURING THE SAME

(57) There is provided a light-emitting device including a second electrode which exhibits a stable behavior in a process for manufacturing a light-emitting device or during an operation of a light-emitting device. A light-emitting device includes a first compound semiconductor layer 11 with an n-type conductivity type, an active layer 12 formed on the first compound semiconductor layer 11 and composed of a compound semiconductor, a second compound semiconductor layer 13 with a p-type conductivity type formed on the active layer 12, a first electrode 15 electrically connected to the first compound semiconductor layer 11, and a second electrode 14 formed on the second compound semiconductor layer 13, wherein the second electrode 14 is composed of a titanium oxide, has an electron concentration of $4 \times 10^{21}/cm^3$ or more, and reflects light emitted from the active layer.

FIG. 1

EP 2 259 343 A1

**Description**

Technical Field

The present invention relates to a semiconductor light-emitting device and a method for manufacturing the same.

Background Art

Semiconductor light-emitting devices such as light-emitting diodes (LED) and the like have, for example, a structure in which a first compound semiconductor layer 11 with an n-type conductivity type, an active layer 12, and a second compound semiconductor layer 13 with a p-type conductivity type are laminated in order on a substrate 10. In addition, a first electrode (n-side electrode) 15 is provided on the substrate or an exposed portion 11A of the first compound semiconductor layer 11, and a second electrode (p-side electrode) 114 is provided on the top of the second compound semiconductor layer 13. Such semiconductor light-emitting devices can be classified into the two types including a type of semiconductor light-emitting device in which light from the active layer 12 is emitted through the second compound semiconductor layer 13 and a type (referred to as a "bottom emission type" for convenience) of semiconductor light-emitting device in which light from the active layer 12 is emitted through the first compound semiconductor layer 11 as disclosed in, for example, WO2003/007390.

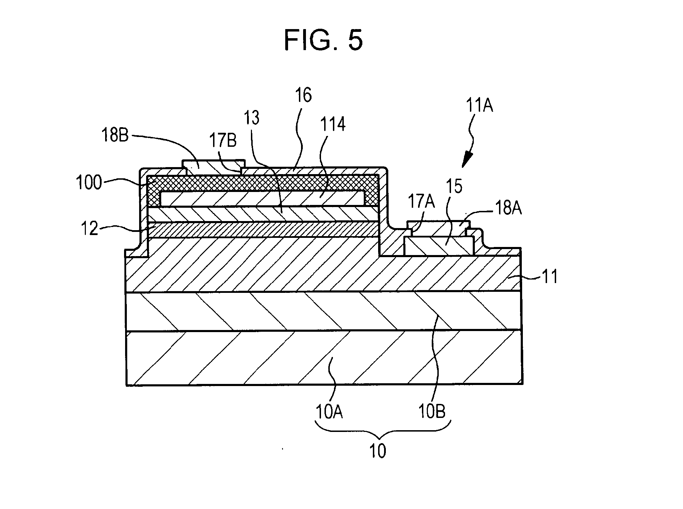

Usually, a conventional bottom emission-type semiconductor light-emitting device frequently uses, as the second electrode 114, a reflecting electrode which reflects visible light from the active layer 12 in order to maintain a high efficiency of emission as shown in Fig. 5. In this case, the second electrode 114 is required to have an electron density sufficient to reflect visible light emitted from the active electrode 12, and the second electrode 114 is composed of, for example, a metal such as silver (Ag), aluminum (Al), or the like. However, the second electrode composed of such a metal easily causes electrical migration in a process for manufacturing a semiconductor light-emitting device or during an operation of a semiconductor light-emitting device, and significantly causes deterioration due to oxidation or the like. Therefore, a coating layer 100 composed of, for example, TiW is often formed to cover the second electrode. Furthermore, other components of the semiconductor light-emitting device shown in Fig. 5 are described in detail below in Embodiment 1 described below.

However, in order to cover the second electrode 114 with the coating layer 100, various processes, for example, formation of the coating layer 100 based on a physical vapor deposition method (PVD method) and patterning of the coating layer 100 by lithography technique and etching technique are required. Thus, the manufacturing cost of a semiconductor light-emitting device is inevitably increased.

Accordingly, an object of the present invention is to provide a semiconductor light-emitting device including a second electrode which exhibits a stable behavior in a process for manufacturing the semiconductor light-emitting device or during an operation of the semiconductor light-emitting device and provide a method for manufacturing the semiconductor light-emitting device.

Disclosure of Invention

In order to achieve the object, a semiconductor light-emitting device according to the present invention includes:

(A) a first compound semiconductor layer with an n-type conductivity type;
(B) an active layer formed on the first compound semiconductor layer and composed of a compound semiconductor;
(C) a second compound semiconductor layer with a p-type conductivity type formed on the active layer;
(D) a first electrode electrically connected to the first compound semiconductor layer; and
(E) a second electrode formed on the second compound semiconductor layer;
the second electrode being composed of a titanium oxide, having an electron concentration of $4 \times 10^{21}/cm^3$ or more, and reflecting light emitted from the active layer.

The semiconductor light-emitting device according to the present invention can take a form in which the semiconductor layer is doped with niobium (Nb), tantalum (Ta), or vanadium (V). In other words, the semiconductor light-emitting device can take a form in which a doping impurity of the second electrode is at least one atom selected from the group consisting of niobium (Nb), tantalum (Ta), and vanadium (V).

In addition, the semiconductor light-emitting device according to the present invention including the above-described preferred form can be configured so that compound semiconductors constituting the first compound semiconductor layer, the active layer, and the second compound semiconductor layer are $Al_X Ga_Y In_{1-X-Y}N$ ($0 \leq X \leq 1$, $0 \leq Y \leq 1$, $0 \leq X + Y \leq 1$).

Further, the semiconductor light-emitting device according to the present invention including the above-described preferred form and configuration is preferably configured so that the crystal structure of the titanium oxide is a rutile structure.

Further, the semiconductor light-emitting device according to the present invention including the above-described preferred form and configuration is preferably configured so that the top surface of the second compound semiconductor layer on which the second electrode is formed has a (0001) plane (also referred to as a "C plane"). In this way, the top surface of the second compound semiconductor layer has a C plane so that high lattice matching with the second electrode can be achieved depending on the compound semiconductor constituting the compound semiconductor layer.

In order to achieve the object, a method for manufacturing a semiconductor light-emitting device according to the present invention includes at least the steps of:

(a) forming a light-emitting portion by laminating in order a first compound semiconductor layer with an n-type conductivity type, an active layer, and a second compound semiconductor layer with a p-type conductivity type on a substrate; and

(b) then forming a second electrode on the second compound semiconductor layer;

wherein compound semiconductors constituting the first compound semiconductor layer, the active layer, and the second compound semiconductor layer are $Al_XGa_YIn_{1-X-Y}N$ ($0 \leq X \leq 1$, $0 \leq Y \leq 1$, $0 \leq X + Y \leq 1$); and

in the step (b), the second electrode composed of a titanium oxide having a rutile crystal structure is epitaxially grown on the top surface of the second compound semiconductor layer having a (0001) plane in a state of being doped with an impurity so that the electron concentration is $4 \times 10^{21}/cm^3$ or more.

The method for manufacturing a semiconductor light-emitting device according to the present invention can take a form in which an impurity is niobium (Nb), tantalum (Ta), or vanadium (V). In other words, the method can take a form in which a doping impurity of the second electrode is at least one atom selected from the group consisting of niobium (Nb), tantalum (Ta), and vanadium (V). In addition, according to circumstances, after the second electrode is formed, an impurity may be implanted in the second electrode by, for example, an ion implantation method from the viewpoint of addition of an impurity.

In the method for manufacturing a semiconductor light-emitting device according to the present invention including the above-described preferred form, the second electrode is preferably formed on the basis of a pulse laser deposition method (PLD method) which is a physical vapor deposition method, but the method is not limited to this and the second electrode can also be formed on the basis of another method, such as a molecular beam epitaxy method (MBE method) or a sputtering method.

In addition, in the semiconductor light-emitting device or the method for manufacturing the same according to the present invention including the above-described preferred form and configuration, a material constituting the second electrode preferably has a property, i.e., a metal-like property, that electric conductivity increases with increases in temperature. In addition, in order to determine whether or not the property is like metals, besides measurement of electric conductivity, a state density of a substance can be measured on the basis of an X-ray photoelectron spectroscopy method (XPS method) to determine whether or not a Fermi edge is present.

Further, the semiconductor light-emitting device or the method for manufacturing the same according to the present invention including the above-described preferred form and configuration preferably has a form in which in the second electrode, a plasma frequency ($\omega$) represented by expression (1) below is 425 nm or less.

$$\omega = \{ (n_e \cdot e^2) / (\varepsilon_0 \cdot m_e) \}^{1/2} \qquad (1)$$

wherein
$n_e$: electron density
$e$: elementary charge
$\varepsilon_0$: dielectric constant of vacuum
$m_e$: rest mass of electrons

In addition, the semiconductor light-emitting device or the method for manufacturing the same according to the present invention including the above-described preferred form and configuration is preferably configured so that light emitted from the active layer is emitted to the outside through the first compound semiconductor layer. Namely, the semiconductor light-emitting derive is preferably a bottom emission type.

In the semiconductor light-emitting device according to the present invention including the above-described preferred form and configuration or the method for manufacturing the semiconductor light-emitting device according to the present invention including the above-described preferred form and configuration (may be generically named "the present invention" hereinafter), as described above, as the compound semiconductor, not only a GaN-based compound semiconductor (including an AlGaN mixed crystal or AlGaInN mixed crystal, and a GaInN mixed crystal) but also an InN-based compound semiconductor and an AlN-based compound semiconductor can be used. In addition, as the method for forming (method for depositing) layers of these semiconductors, a metal-organic chemical vapor deposition method (MOCVD method), a MBE method, and a hydride vapor deposition method in which a halogen contributes to transport or reaction can be used. Examples of an n-type impurity added to compound semiconductor layers include silicon (Si), selenium (Se), germanium (Ge), tin (Sn), carbon (C), and titanium (Ti). Examples of a p-type impurity include zinc (Zn), magnesium (Mg), beryllium (Be), cadmium (Cd), calcium (Ca), barium (Ba), and oxygen (O).

Substrates which can be used as the substrate in the present invention include a sapphire substrate, a GaAs substrate, a GaN substrate, a SiC substrate, an alumina substrate, a ZnS substrate, a ZnO substrate, an AlN substrate, a LiMgO substrate, a LiGaO$_2$ substrate, a MgAl$_2$O$_4$ substrate, an InP substrate, a Si substrate, a Ga substrate, and these substrates each including an underlying layer and a buffer layer formed on a surface (main surface). In the present invention, the semiconductor light-emitting device is first provided on the substrate, but a form in which the semiconductor light-emitting device is formed on the substrate or a form in which the substrate is removed can be used as a final form of the semiconductor light-emitting device.

In the semiconductor light-emitting device according to the present invention including the above-described preferred form and configuration or the method for manufacturing the semiconductor light-emitting device according to the present invention including the above-described preferred form and configuration (may be generically named "the semiconductor light-emitting device, etc. of the present invention" hereinafter), as a material constituting the first electrode, the first electrode can be composed of titanium (Ti) or a titanium alloy such as TiW or TiMo (for example, a TiW layer, a Ti layer/Ni layer/Au layer, or the like), or aluminum (Al), an aluminum alloy, AuGe, AuGe/Ni/Au, or the like. In addition, when the electrode has a multilayer structure, a material shown in front of "/" is disposed on the substrate side. For the first electrode and the second electrode, a contact portion (pad portion) including a multilayer metal layer having a laminated configuration, such as [adhesive layer (a Ti layer, a Cr layer, or the like)/[barrier metal layer (a Pt layer, a Ti layer, a TiW layer, a Mo layer, or the like)]/[metal layer having good compatibility in mounting (for example, an Au layer)], for example, a Ti layer/Pt layer/Au layer or the like, may be provided according to demand. The first electrode and the contact portion (pad portion) can be formed by any of various PVD methods such as a vacuum evaporation method and a sputtering method, various chemical vapor deposition methods (CVD methods), and a plating method.

Specifically, for example, a light-emitting diode (LED), an edge emission-type semiconductor laser, a surface emitting laser device (vertical resonator laser, VCSEL) can be configured using the semiconductor light-emitting device, etc. of the present invention.

In the semiconductor light-emitting device, etc. of the present invention, the second electrode reflects light emitted from the active layer, but the expression "the second electrode reflects light" represents that optical reflectance at a wavelength for 380 nm to 800 nm is 40% or more. The optical reflectance of the second electrode can be determined by comparing relative reflected light intensity with a dielectric multilayer film as a base theoretically having an optical reflectance of 100%. The electron concentration of the second electrode can be determined on the basis of hole measurement (Van der Pauw method).

In the present invention, since the second electrode is composed of a titanium oxide having a high electron density, not only high conductivity can be achieved, but also high optical reflectance can be achieved. As a result, the emission efficiency of the semiconductor light-emitting device can be significantly improved. In addition, since the second electrode is composed of a titanium oxide, a problem of deterioration due to oxidation does not occur, and electric migration does not occur because the titanium oxide is a very stable substance. Therefore, the second electrode need not be covered with a coating layer, and thus an attempt can be made to simplify the process for manufacturing the semiconductor light-emitting device and decrease the manufacturing cost of the semiconductor light-emitting device.

Brief Description of Drawings

[Fig. 1] Figs. 1(A) and (B) are a schematic layout drawing of components of a semiconductor light-emitting device of Embodiment 1 and a schematic sectional view of a semiconductor light-emitting device of Embodiment 1 taken along arrow B-B in Fig. 1(A), respectively.
[Fig. 2] Fig. 2 is a graph showing a relation between electron concentration and plasma frequency in terms of wavelength.
[Fig. 3] Figs. 3(A) and (B) are schematic partial end views of a substrate, etc. for explaining a method for manufacturing a semiconductor light-emitting device of Embodiment 1.
[Fig. 4] Figs. 4(A) and (B) are schematic partial end views of a substrate, etc. for explaining a method for manufacturing a semiconductor light-emitting device of Embodiment 1 in succession to Fig. 3(B).
[Fig. 5] Fig. 5 is a schematic sectional view of a conventional semiconductor light-emitting device.

Best Mode for Carrying Out the Invention

Although the present invention is described below on the basis of an embodiment with reference to the drawings, a second electrode of the present invention is taken into consideration prior to the description.

It is known that high conductivity equal to that of ITO can be obtained by doping a titanium oxide with pentavalent niobium (Nb) or tantalum (Ta), i.e. , forming $Ti_{1-Z}A_ZO_2$ (A is a pentavalent impurity) (refer to, for example, T. Hitotsugi, A. Ueda, Y. Furubayashi, Y. Hirose, S. Nomura, T. Shimada, T. Hasegawa, Jpn. J. Appl. Phys. 46, L86 (2007), N. Yamada, T. Hitotsugi, N. L. Kuong, Y. Furubayashi, Y. Hirose, T. Shimada, T. Hasegawa, Jpn. J. Appl. Phys. 46, 5275 (2007), T. Hitotsugi, Y. Furubayashi, A. Ueda, K. Itabashi, K. Inaba, Y. Hirose, G. Kinoda, Y. Yamamoto, T. Shimada, T. Hasegawa, Jpn. J. Appl. Phys. 44, L1063 (2005), Y. Furubayashi, T. Hitotsugi, Y. Yamamoto, K. Inaba, G. Kinoda, T. Shimada, T. Hasegawa, Appl. Phys. Lett. 86, 252101 (2005), and T. Hitotsugi, A. Ueda, S. Nakano, N. Yamada, Y. Furubayashi, Y. Hirose, T. Shimada, T. Hasegawa, Appl. Phys. Lett. 90, 212106 (2007)). Here, assuming free electrons without itinerancy on the basis of the Drude's electron theory, plasma frequency ($\omega$) referred to as "plasmon" can be determined according to expression (1) (refer to, for example, C. Kittel "Introduction to Solid State Physics, 7th edition, p. 304 (1998)).

$$\omega \; = \; \{ (n_e \cdot e^2) / (\varepsilon_0 \cdot m_e) \}^{1/2} \qquad\qquad (1)$$

wherein
$n_e$: electron density
e: elementary charge
$\varepsilon_0$: dielectric constant of vacuum
$m_e$: rest mass of electrons.

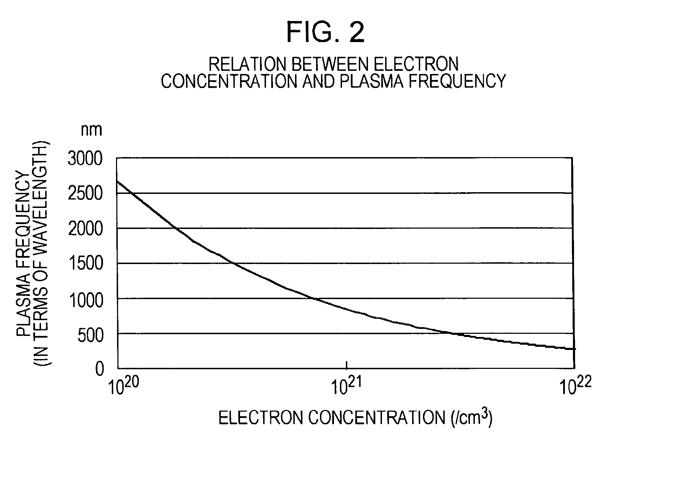

The plasmon is quantized electron oscillation and light with energy lower than this is theoretically totally reflected. Therefore, light in the visible region can be totally reflected by increasing the electron concentration in a titanium oxide to a plasma frequency or more. It is said that in a titanium oxide, the activation rate of an impurity such as Nb or Ta is about 80%. Therefore, the electron concentration (carrier concentration) becomes $4 \times 10^{21}/cm^3$ by doping with $5 \times 10^{21}/cm^3$ of impurity, and light up to about 423 nm can be totally reflected (refer to Fig. 2). In addition, in Fig. 2, the abscissa indicates the electron concentration, and the ordinate indicates the plasma frequency in terms of wavelength. Of course, a higher plasma frequency can be achieved by doping a higher concentration of impurity.

In addition, a titanium oxide is a very stable substance, and thus the second electrode composed of the titanium oxide has very strong process resistance, heat resistance, and electric resistance. Further, it is known that a rutile-type titanium oxide (titanium dioxide, titanium(IV) oxide) is stable in air, and a titanium oxide (may be referred to as "rutile-type $TiO_2$") having a rutile structure undergoes heteroepitaxial growth on a C-plane of GaN (refer to, for example, T. Hitotsugi, Y. Hirose, J. Kasai, Y. Furubayashi, M. Ohtani, K. Nakajima, T. Chilyow, T. Shimada, T. Hasegawa, Jpn. J. Appl. Phys. 44, L1503 (2005). Therefore, heteroepitaxial growth of the second electrode on the C-plane of the second compound semiconductor layer can provide an electrically good interface at an interface between the compound semiconductor layer and the second electrode without causing a level due to a defect or the like.

EMBODIMENT 1

Embodiment 1 relates to a semiconductor light-emitting device of the present invention and a method for manufacturing the same.

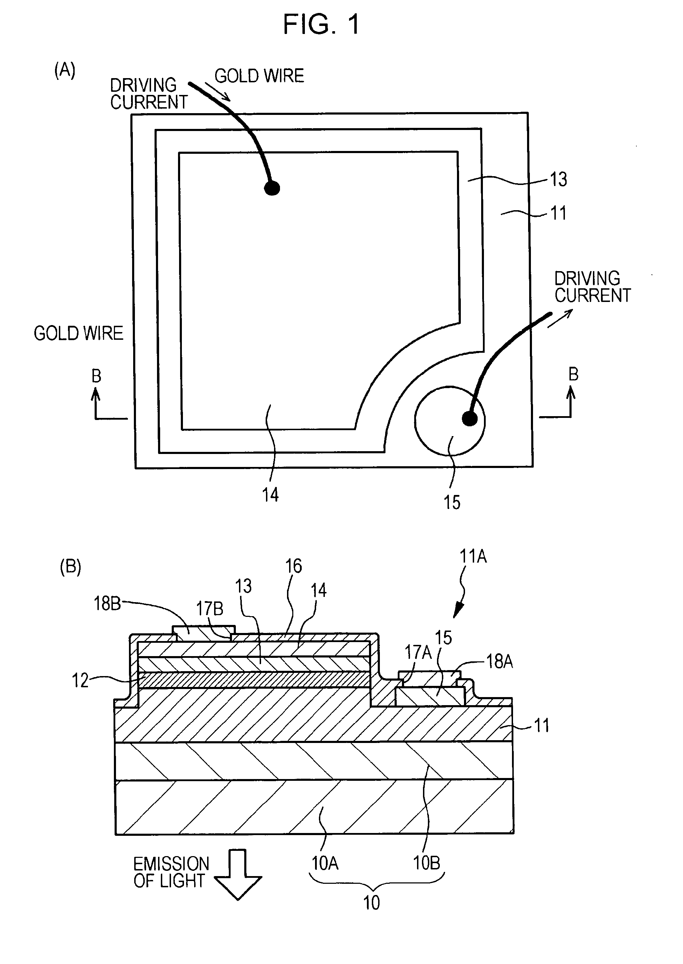

A semiconductor light-emitting device of Embodiment 1 includes a light-emitting diode (LED), and as shown in Fig. 1(A) which is a schematic layout drawing of components and Fig. 1(B) which is a schematic sectional view taken along arrow B-B in Fig. 1(A), is provided with:

(A) a first compound semiconductor layer 11 having an n-type conductivity type;
(B) an active layer 12 formed on the first compound semiconductor layer 11 and composed of a compound semiconductor;
(C) a second compound semiconductor layer 13 formed on the active layer 12 and having a p-type conductivity type;
(D) a first electrode 15 electrically connected to the first compound semiconductor layer 11; and

(E) a second electrode 14 formed on the second compound semiconductor layer 13.

In addition, the second electrode 14 is composed of a titanium oxide, specifically a titanium oxide having a rutile crystal structure, has an electron concentration of $4 \times 10^{21}/cm^3$ or more, and reflects light emitted from the active layer 12. That is, the semiconductor light-emitting device of Embodiment 1 is a bottom emission type in which light emitted from the active layer 12 is emitted to the outside through the first compound semiconductor layer 11. Herein, in the second electrode 14, a titanium oxide (rutile-type $TiO_2$) is doped with niobium (Nb) or tantalum (Ta). The value of electron concentration determined in the second electrode 14 based on hole measurement (Van der Pauw method) is $4 \times 10^{21}/cm^3$. Therefore, in the second electrode 14, the plasma frequency (ω) represented by the above expression (1) is 425 nm or less. The material (rutile-type $TiO_2$ doped with Nb or Ta) constituting the second electrode 14 has a property, i.e., a metal-like property, that the electric conductivity increases with increases in temperature.

Herein, a substrate 10 includes a substrate 10A composed of, for example, sapphire, and an underlying layer 10B formed on the substrate 10A and composed of GaN. In addition, the compound semiconductors constituting the first compound semiconductor layer 11, the active layer 12, and the second compound semiconductor layer 13 are composed of $Ai_XGa_YIn_{1-X-Y}N (0 \le X \le 1, 0 \le Y \le 1, 0 \le X + Y \le 1)$, more specifically GaN-based compound semiconductors. That is, the first compound semiconductor layer 11 is composed of Si-doped GaN (GaN:Si), the active layer 12 is composed of an InGaN layer (well layer) and a GaN layer (barrier layer) and has a multiquantum well structure. In addition, the second compound semiconductor layer 13 is composed of Mg-doped GaN (GaN:Mg). In addition, a light-emitting portion is configured by a laminated structure in which the first compound semiconductor layer 11, the active layer 12, and the second compound semiconductor layer 13 are laminated. Further, the top surface of the second compound semiconductor layer 13 on which the second electrode 14 is formed has a (0001) plane which is a C-plane.

Further, the first electrode 15 is provided on a portion 11A of the first compound semiconductor layer 11 which is exposed by partially removing (etching) the second compound semiconductor layer 13 and the active layer 12. In addition, when a current is passed from the second electrode 14 to the first compound semiconductor layer 11 and the first electrode 15 through the active layer 12 which is positioned immediately below the remaining second compound semiconductor layer 13, in the active layer 12, the quantum well structure of the active layer 12 is excited by current injection, creating a light emission state over the entire surface. In addition, Fig. 1(A) shows only part of the components of the light-emitting diode.

Also, in the light-emitting diode of Embodiment 1, a first contact portion (first pad portion) 18A is formed on the first electrode 15 to extend from a first opening 17A provided in an insulating layer 16 to the top of the insulating layer 16, and a second contact portion (second pad portion) 18B is formed on the second electrode 14 to extend from a second opening 17B provided in the insulating layer 16 to the top of the insulating layer 16. A material constituting the insulating layer 16 can be exemplified by a $SiO_X$-based material, a $SiN_X$-based material, a $SiO_XN_Y$-based material, $Ta_2O_5$, $ZrO_2$, AlN, and $Al_2O_3$.

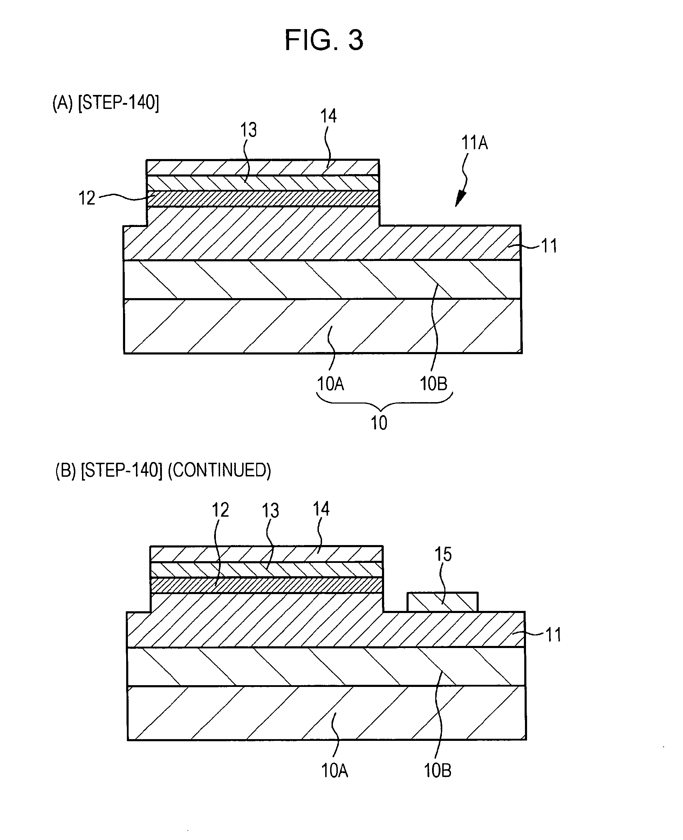

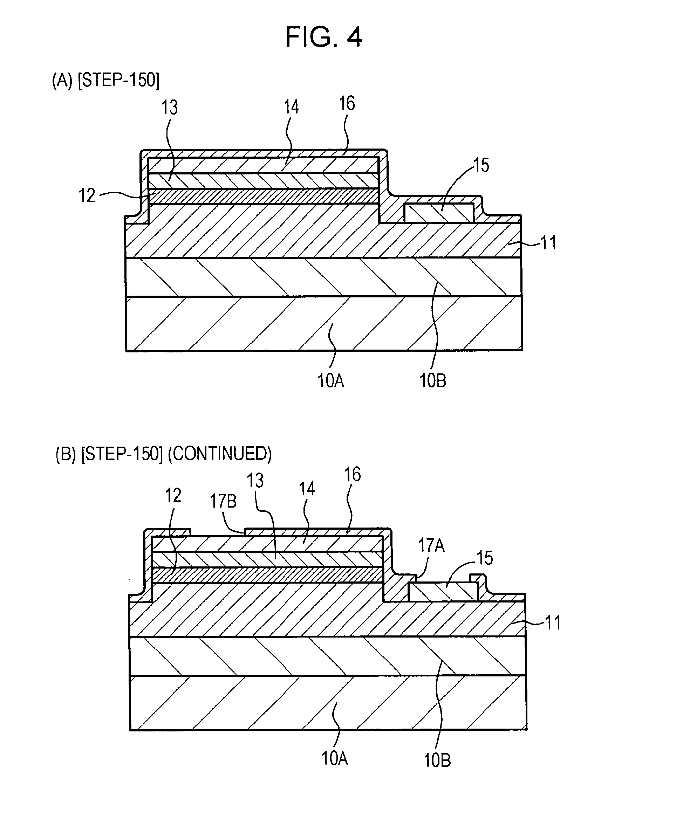

The method for manufacturing the semiconductor light-emitting device of Embodiment 1 is described below with reference to schematic partial sectional views of Figs. 3(A) and (B) and Figs. 4(A) and (B) which shows the substrate, etc.

[Step-100]

First, the substrate 10A composed of sapphire is transferred to a MOCVD apparatus and cleaned at a substrate temperature of 1050°C for 10 minutes in a carrier gas containing hydrogen, and then the substrate temperature is decreased to 500°C. Then, the underlying layer 10B composed of GaN is crystal-grown on a surface of the substrate 10A by supplying a trimethylgallium (TMG) gas as a gallium raw material while supplying an ammonia gas as a nitrogen raw material on the basis of a MOCVD method, and then supply of the TMG gas is stopped.

[Step-110]

Next, the first compound semiconductor layer 11 having an n-type conductivity type, the active layer 12, and the second compound semiconductor layer 13 having a p-type conductivity type are laminated in order on the substrate 10 to form the light-emitting portion.

Specifically, on the basis of the MOCVD method, the substrate temperature is increased to 1020°C, and then supply of a monosilane ($SiH_4$) gas as a silicon raw material is started at normal pressure to crystal-grow the first compound semiconductor layer 11 on the underlying layer 10B, the first compound semiconductor layer 11 being composed of Si-doped GaN (GaN:Si) and having an n-type conductivity type and a thickness of 3 μm. In addition, the doping concentration is about $5 \times 10^{18}/cm^3$.

Then, supply of the TMG gas and the $SiH_4$ gas is stopped, and the substrate temperature is decreased to 750°C. Then, triethyl gallium (TEG) gas and trimethyl indium (TMI) gas are used and these gases are supplied by valve switching to crystal-grow the active layer 12 composed of InGaN and GaN and having a multiquantum well structure.

For example, in a light-emitting diode with an emission wavelength of 400 nm, a multiquantum well structure (for example, including 2 well layers) composed of InGaN having an In ratio of about 9% and GaN (thicknesses of 2.5 nm and 7.5 nm, respectively) may be formed. In addition, in a blue light-emitting diode with an emission wavelength of 460 nm $\pm$ 10 nm, a multiquantum well structure (for example, including 15 well layers) composed of InGaN having an In ratio of about 15% and GaN (thicknesses of 2.5 nm and 7.5 nm, respectively) may be formed. Further, in a green light-emitting diode with an emission wavelength of 520 nm $\pm$ 10 nm, a multiquantum well structure (for example, including 9 well layers) composed of InGaN having an In ratio of about 23% and GaN (thicknesses of 2.5 nm and 15 nm, respectively) may be formed.

After the formation of the active layer 12 is completed, supply of the TEG gas and the TMI gas is stopped, the carrier gas is changed from nitrogen to hydrogen, the substrate temperature is increased to 850°C, and supply of a TMG gas and biscyclopentadienylmagnesium ($Cp_2MG$) gas is started to crystal-grow the second compound semiconductor layer 13 on the active layer 12, the second compound semiconductor layer 13 being composed of Mg-doped GaN (GaN: Mg) and having a thickness of 100 nm. In addition, the doping concentration is about $5 \times 10^{19}/cm^3$. Then, supply of the TMG gas and the $Cp_2MG$ gas is stopped, and the substrate temperature is decreased to room temperature, completing crystal growth.

[Step-120]

After the crystal growth is completed as described above, the p-type impurity (p-type dopant) is activated by annealing at about 800°C for 10 minutes in a nitrogen gas atmosphere.

[Step-130]

Next, as the second electrode (p-side electrode) 14, $Ti_{1-z}AzO_2$ (A is a pentavalent impurity, specifically Nb or Ta) is deposited on the second compound semiconductor layer on the basis of a PLD method. Specifically, the second electrode 14 is deposited, for example, under the conditions shown in Table 1 below. Next, $TiO_X$ (X > 2) constituting the peroxidized second electrode 14 can be converted to $TiO_2$ by, for example, reduction annealing under the conditions of 400°C for 5 minutes in a hydrogen atmosphere. In this case, the impurity concentration is such a value that the carrier concentration is $4 \times 10^{21}/cm^3$ or more so that the light emitted from the active layer 12 is reflected by the second electrode 14. For example, as described above, in case of Nb or Ta, the dose may be about $5 \times 10^{21}/cm^3$ or more because the electric activation rate in $TiO_2$ is about 80%. In addition, in general, assuming that the electric activation rate of impurity in $TiO_2$ is $\alpha$, the dose of the impurity may be $4 \times 10^{21} \times (1/\alpha)/cm^3$ or more. Also, rutile-type $TiO_2$ is known to grow heteroepitaxially on a C-plane of GaN, and a good interface can be easily obtained.

[Table 1]

Laser light source: KrF excimer laser (wavelength: 248 nm)
Strength: $2J/cm^2$ 2 Hz
Target: sintered body of $TiO_2$ powder ($Nb_2O_5$ or $Ta_2O_5$ added as Nb or Ta)
Distance from target to second compound semiconductor layer: about 50 mm
Process gas: $O_2$ substrate temperature: 250°C

[Step-140]

Then, the first compound semiconductor layer 11 is partially exposed. Specifically, a portion 11A of the first compound semiconductor layer 11 is exposed by partially removing the second electrode 14, the second compound semiconductor layer 13, and the active layer 12 on the basis of a lithography technique and a dry etching technique (see Fig. 3(A)). Then, the first electrode 15 is formed on the exposed portion of the first compound semiconductor layer 11 on the basis of a liftoff method. Specifically, a resist layer is formed over the entire surface, and an opening is formed in the resist layer on the portion of the first compound semiconductor layer on which the first electrode 15 is to be formed. Then, a metal layer (for example, a Ti layer) constituting the first electrode 15 is deposited over the entire surface by a sputtering method, and then the first electrode 15 can be formed by removing the resist layer (see Fig. 3(B)).

[Step-150]

Then, at least an exposed portion of the first compound semiconductor layer 11, an exposed portion of the active layer 12, an exposed portion of the second compound semiconductor layer 13, and a portion of the second electrode 14 are covered with the insulating layer 16 (refer to Fig. 4(A)). As a method for forming the insulating layer 16, for example, a PVD method such as a vacuum evaporation method or a sputtering method, or a CVD method can be used. Then, the first opening 17A and the second opening 17B are formed in a portion of the insulating layer 16 on the first electrode 15 and a portion of the insulating layer 16 on the second electrode 14, respectively, on the basis of lithography technique and dry etching technique (refer to Figs. 4(B)). Next, the first contact portion (first pad portion) 18A extending from the first electrode 15 to the top of the insulating layer 16 through the first opening 17A is formed and, at the same time, the second contact portion (second pad portion) 18B extending from the second electrode 14 to top of the insulating layer 16 through the second opening 17B is formed. In addition, the first contact portion (first pad portion) 18A and the second contact portion (second pad portion) 18B each include, for example, a Ti layer/Pt layer formed by a vacuum evaporation method and an Au layer formed thereon by a plating method. Then, a chip is formed by dicing to obtain the semiconductor light-emitting device (light-emitting diode) shown in Fig. 1. Further, various semiconductor light-emitting devices (specifically, light-emitting diodes) of a bullet type and a surface mounting type can be formed by resin molding or packaging.

In Embodiment 1, the second electrode 14 is composed of a titanium oxide doped with an impurity and having a high electron density, and thus not only high conductivity can be achieved, but also high optical reflectance can be achieved. As a result, the emission efficiency of the semiconductor light-emitting device can be significantly improved. In addition, since the second electrode 14 is composed of a titanium oxide, deterioration due to oxidation does not occur, and electrical migration does not occur. Therefore, unlike in a conventional technique, the second electrode 14 need not be covered with a coating layer, and thus an attempt can be made to simplify the process for manufacturing the semiconductor light-emitting device and decrease the manufacturing cost of the semiconductor light-emitting device. In addition, since a titanium oxide doped with an impurity has a high work function, a low Schottky barrier is produced between the second electrode 14 and the second compound semiconductor layer 13 having a p-type conductivity type, and thus a good ohmic contact can be achieved as an electric connection between the second electrode 14 and the second compound semiconductor layer 13.

Although the present invention described above on the basis of the preferred embodiment, the present invention is not limited to this embodiment. The configurations and structures of the semiconductor light-emitting device described in the embodiment, the materials constituting the semiconductor light-emitting device, and the manufacturing conditions and various numerical values of the semiconductor light-emitting device are exemplary and can be appropriately changed. For example, in the semiconductor light-emitting device described in Embodiment 1, the form of being formed on the substrate is described as the final form of the semiconductor light-emitting device, but alternatively, a structure can be formed, in which the first electrode 15 is formed on the first compound semiconductor layer 11 exposed by polishing or etching the substrate. In addition, by using a substrate with conductivity, the first compound semiconductor layer, etc. may be formed on a main surface (front surface) of the substrate, and the first electrode 15 may be formed on the back surface of the substrate.

## Claims

1. A semiconductor light-emitting device comprising:

   (A) a first compound semiconductor layer with an n-type conductivity type;
   (B) an active layer formed on the first compound semiconductor layer and composed of a compound semiconductor;
   (C) a second compound semiconductor layer with a p-type conductivity type formed on the active layer;
   (D) a first electrode electrically connected to the first compound semiconductor layer; and
   (E) a second electrode formed on the second compound semiconductor layer,

   wherein the second electrode is composed of a titanium oxide, has an electron concentration of $4 \times 10^{21}/cm^3$ or more, and reflects light emitted from the active layer.

2. The semiconductor light-emitting device according to Claim 1, wherein the second electrode is doped with niobium or tantalum.

3. The semiconductor light-emitting device according to Claim 1, wherein compound semiconductors constituting the first compound semiconductor layer, the active layer, and the second compound semiconductor layer are $Al_XGa_YIn_{1-X-Y}N$ ($0 \leq X \leq 1$, $0 \leq Y \leq 1$, $0 \leq X + Y \leq 1$).

4. The semiconductor light-emitting device according to Claim 1, wherein the crystal structure of the titanium oxide is a rutile structure.

5. The semiconductor light-emitting device according to Claim 1, wherein the top surface of the second compound semiconductor layer on which the second electrode is formed has a (0001) plane.

6. The semiconductor light-emitting device according to Claim 1, wherein a material constituting the second electrode has a property that electric conductivity increases with increases in temperature.

7. The semiconductor light-emitting device according to Claim 1, wherein in the second electrode, a plasma frequency ($\omega$) represented by expression (1) below is 425 nm or less.

$$\omega \; = \; \{ (n_e \cdot e^2) / (\varepsilon_0 \cdot m_e) \}^{1/2} \qquad\qquad (1)$$

wherein
$n_e$: electron density
e: elementary charge
$\varepsilon_0$: dielectric constant of vacuum $m_e$: rest mass of electrons

8. The semiconductor light-emitting device according to Claim 1, wherein light emitted from the active layer is emitted to the outside through the first compound semiconductor layer.

9. A method for manufacturing a semiconductor light-emitting device comprising at least the steps of:

   (a) forming a light-emitting portion by laminating in order a first compound semiconductor layer with an n-type conductivity type, an active layer, and a second compound semiconductor layer having a p-type conductivity type on a substrate; and
   (b) then forming a second electrode on the second compound semiconductor layer,

   wherein compound semiconductors constituting the first compound semiconductor layer, the active layer, and the second compound semiconductor layer are $Al_X Ga_Y In_{1-X-Y}N$ ($0 \leq X \leq 1$, $0 \leq Y \leq 1$, $0 \leq X + Y \leq 1$); and
   in the step (b), the second electrode composed of a titanium oxide with a rutile crystal structure is epitaxially grown on the top surface of the second compound semiconductor layer having a (0001) plane in a state of being doped with an impurity so that the electron concentration is $4 \times 10^{21}/cm^3$ or more.

10. The method for manufacturing a semiconductor light-emitting device according to Claim 9, wherein the impurity is niobium or tantalum.

11. The method for manufacturing a semiconductor light-emitting device according to the Claim 9, wherein the second electrode is formed on the basis of a pulse laser deposition method.

12. The method for manufacturing a semiconductor light-emitting device according to the Claim 9, wherein a material constituting the second electrode has a property that electric conductivity increases with increases in temperature.

13. The method for manufacturing a semiconductor light-emitting device according to the Claim 9, wherein in the second electrode, a plasma frequency ($\omega$) represented by expression (1) below is 425 nm or less.

$$\omega \; = \; \{ (n_e \cdot e^2) / (\varepsilon_0 \cdot m_e) \}^{1/2} \qquad\qquad (1)$$

wherein
$n_e$: electron density
e: elementary charge
$\varepsilon_0$: dielectric constant of vacuum
$m_e$: rest mass of electrons

**14.** The method for manufacturing a semiconductor light-emitting device according to the Claim 9, wherein light emitted from the active layer is emitted to the outside through the first compound semiconductor layer.

# FIG. 1

(A)

DRIVING
CURRENT

GOLD WIRE

GOLD WIRE

DRIVING
CURRENT

B

B

13

11

14

15

(B)

18B   17B   13   16   14        11A

12                                    15

10A   10B

17A   18A

11

EMISSION
OF LIGHT

10

# FIG. 2

RELATION BETWEEN ELECTRON
CONCENTRATION AND PLASMA FREQUENCY

# FIG. 3

(A) [STEP-140]

(B) [STEP-140] (CONTINUED)

# FIG. 4

(A) [STEP-150]

(B) [STEP-150] (CONTINUED)

## FIG. 5

## INTERNATIONAL SEARCH REPORT

| | International application No. |
|---|---|
| | PCT/JP2009/054849 |

A.  CLASSIFICATION OF SUBJECT MATTER
*H01L33/00*(2006.01)i, *H01L21/28*(2006.01)i

According to International Patent Classification (IPC) or to both national classification and IPC

B.  FIELDS SEARCHED

Minimum documentation searched (classification system followed by classification symbols)
H01L33/00, H01S5/00-5/50

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)
JSTPlus(JDreamII)

C.  DOCUMENTS CONSIDERED TO BE RELEVANT

| Category* | Citation of document, with indication, where appropriate, of the relevant passages | Relevant to claim No. |
|---|---|---|
| A | JP 2007-220970 A  (Showa Denko Kabushiki Kaisha), 30 August, 2007 (30.08.07), Full text; all drawings (Family: none) | 1-14 |
| A | WO 2007/125860 A1  (Showa Denko Kabushiki Kaisha), 08 November, 2007 (08.11.07), Full text; all drawings & JP 2007-294578 A | 1-14 |
| A | WO 2006/073189 A1  (Kanagawa Academy of Science and Technology), 13 July, 2006 (13.07.06), Full text; all drawings & KR 10-2007-0099591 A  & CN 101099227 A | 1-14 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 March, 2009 (26.03.09) | 07 April, 2009 (07.04.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/054849

C (Continuation).   DOCUMENTS CONSIDERED TO BE RELEVANT

| Category* | Citation of document, with indication, where appropriate, of the relevant passages | Relevant to claim No. |
|---|---|---|
| A | Taro HITOSUGI et al., "TiO$_2$-kei Tomei Dodentai no Sputter Seimaku Gijutsu", The Journal of the Surface Finishing Society of Japan, 01 December, 2007 (01.12.07), Vol.58, No.12, pages 798 to 803 | 1-14 |
| A | Taro HITOSUGI et al., Heteroepitaxial Growth of Rutile TiO$_2$ on GaN(0001) by Pulsed Laser Deposition, Japanese Journal of Applied Physics, 2005, Vol.44, No.50, pp.L1503-L1505 | 1-14 |
| A | Yutaka Furubayashi et al., A transparent metal: Nb-doped anatase TiO$_2$, APPLIED PHYSICS LETTERS, 2005, Vol.86, p.252101 | 1-14 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2003007390 A

### Non-patent literature cited in the description

- **T. Hitotsugi ; A. Ueda ; Y. Furubayashi ; Y. Hirose ; S. Nomura ; T. Shimada ; T. Hasegawa.** *Jpn. J. Appl. Phys.,* 2007, vol. 46, L86
- **N. Yamada ; T. Hitotsugi ; N. L. Kuong ; Y. Furubayashi ; Y. Hirose ; T. Shimada ; T. Hasegawa.** *Jpn. J. Appl. Phys.,* 2007, vol. 46, 5275
- **T. Hitotsugi ; Y. Furubayashi ; A. Ueda ; K. Itabashi ; K. Inaba ; Y. Hirose ; G. Kinoda ; Y. Yamamoto ; T. Shimada ; T. Hasegawa.** *Jpn. J. Appl. Phys.,* 2005, vol. 44, L1063
- **Y. Furubayashi ; T. Hitotsugi ; Y. Yamamoto ; K. Inaba ; G. Kinoda ; T. Shimada ; T. Hasegawa.** *Appl. Phys. Lett.,* 2005, vol. 86, 252101
- **T. Hitotsugi ; A. Ueda ; S. Nakano ; N. Yamada ; Y. Furubayashi ; Y. Hirose ; T. Shimada ; T. Hasegawa.** *Appl. Phys. Lett.,* 2007, vol. 90, 212106
- **C. Kittel.** Introduction to Solid State Physics. 1998, 304
- **T. Hitotsugi ; Y. Hirose ; J. Kasai ; Y. Furubayashi ; M. Ohtani ; K. Nakajima ; T. Chilyow ; T. Shimada ; T. Hasegawa.** *Jpn. J. Appl. Phys.,* 2005, vol. 44, L1503